Europäisches Patentamt

European Patent Office

Office européen des brevets

(19)

(11) Publication number: **0 251 682**
**A2**

(12) **EUROPEAN PATENT APPLICATION**

(21) Application number: **87305627.9**

(22) Date of filing: **24.06.87**

(51) Int. Cl.⁴: **H01L 27/06 , H01L 29/68**

(30) Priority: **25.06.86 US 878462**

(43) Date of publication of application:
**07.01.88 Bulletin 88/01**

(84) Designated Contracting States:
**DE FR GB NL**

(71) Applicant: **Hewlett-Packard Company**
**Mail Stop 20 B-O 3000 Hanover Street**
**Palo Alto California 94304(US)**

(72) Inventor: **Colinge, Jean-Pierre**
**2143 Park Boulevard**
**Palo Alto California 94306(US)**

(74) Representative: **Colgan, Stephen James et al**
**CARPMAELS & RANSFORD 43 Bloomsbury**
**Square**
**London WC1A 2RA.(GB)**

(54) **Integrated bipolar-MOS device.**

(57) A hybrid bipolar/MOS component 10 character-
ized by a transistor portion 12 having an emitter 26,
base 28, and collector 30; a gate portion 14 applied
over the base 28 of the bipolar transistor portion 12;
and a connecting portion 16 coupling the gate por-
tion 14 to the base 28 of the bipolar transistor
portion 12. The emitter 26 of the bipolar transistor 12
also serves as a MOS transistor source, and the
collector 30 of the bipolar transistor also serves as
drain of the MOS transistor. In the essence, the
hybrid component 10 can be thought of as the
parallel connection of a bipolar transistor 12 and a
MOS transistor, where the base 28 of the bipolar
transistor 12 is the body of the MOS transistor.
Preferably, the hybrid component 10 has an insulat-
ing substrate 24 to minimize parasitic capacitance
problems.

FIG 2

# INTEGRATED BIPOLAR-MOS DEVICE

## Background of the Invention

### 1. Field of the Invention

This invention relates generally to integrated circuit devices, and more particularly to integrated circuit devices having both bipolar and MOS components.

### 2. Description of the Prior Art

The design of an integrated circuit device is usually based on either bipolar technology or MOS technology. Bipolar technology, in general, produces faster devices than devices produced by MOS technology. However, MOS technology is easier to implement, and generally produces devices with much lower power requirements.

Individual components within an integrated circuit device are formed on a substrate and are interconnected by conductive traces. Typically, the substrate is a lightly doped semiconductor over which successive semiconductive, insulative, and conductive layers are deposited.

While the techniques and technology for producing electronic components on bulk semiconductor substrates (bulk silicon) are well known and easily implemented, devices produced by bulk silicon techniques possess some undesirable traits. For example, a MOS transistor formed on bulk silicon has undesirably high parasitic source and drain capacitances, which slow down the operation of the MOS transistor and increases its power consumption.

One way to reduce the aforementioned parasitic capacitance problem is to use silicon-on-insulator (SOI) technology. With SOI technology, active semiconductor components are formed on top of an insulating substrate, such as silicon dioxide, greatly reducing the capacitive effect between the components and the underlying substrate.

The formation of bipolar transistors using SOI technology has been explored by various engineers and research scientists. For example, Rodder et al. in an article entitled "Silicon-on-Insulator Bipolar Transistors", IEEE Electron Device Letters, Vol. EDL-4, No. 6, June, 1983, teach thin-film, lateral, NPN bipolar transistors fabricated over a silicon dioxide substrate. Rodder et al. further teach an oxide layer applied to the base region of the NPN bipolar transistor, and a metal gate formed over the oxide. This configuration permits the transistor to be operated as an N-channel MOSFET, and further permits the study of device characteristics under varying gate bias voltages. Maximum DC current gain values of 2.5 were achieved with a 5 micron base-width, and values of about .5 were achieved with a 10 micron base-width.

The test device of Rodder et al. had an exceedingly low DC current gain for several reasons. For one, Rodder et al. were unable to create an NPN bipolar transistor with a narrow base-width in conjunction with a MOS-type gate. Also, the test device of Rodder et al. was never operated in both the bipolar mode and the MOS mode simultaneously. In other words, with Rodder et al. the test device was either operated as an NPN bipolar transistor, or as an N-channel MOSFET transistor, but never as a combination of the two. However, even if Rodder et al. had operated the test device as a combination bipolar/MOS device, they would not have noted any current gain due to the test device's wide base-width.

An article entitled "Fully Isolated Lateral Bipolar-MOS Transistors Fabricated in Zone-Melting-Recrystalized Si Films on SiO$_2$" by Tsaur et al., IEEE Electron Device Letter, Vol. EDL-4, No. 8, August, 1983, teaches another integrated circuit device that includes both bipolar transistors and MOS transistors formed over an insulating substrate. In Tsaur et al.'s disclosure, a four terminal device is described which can be operated either as an NPN bipolar transistor or, in the alternative, as a conventional N-channel MOSFET. Common emitter current gains of about 20 were observed during bipolar operation. While Tsaur et al.'s bipolar transistors exhibit greater current gains than those disclosed by Rodder et al., their gains are still rather low compared to current gains achieved with conventional bipolar technology.

## Summary of the Invention

An object of this invention is to provide transistor components which are characterized by high speed operation, high gain, low production cost, and low power dissipation.

Another object of this invention is to provide transistor components which have higher gains than conventional bipolar and MOS transistors.

Yet another object of this invention is to provide transistor components which are particularly well-suited for use in high-speed inverter circuits.

Briefly, a hybrid bipolar/MOS component in accordance with the present invention includes a bipolar transistor portion having an emitter, a base, and a collector; a gate portion formed over the base; and an electrical connection coupling the gate portion to the base. The gate portion includes a gate insulator formed over the base, and a gate conductor formed over the gate insulator. The electrical connection between the gate portion and the base may be made by highly conductive materials, such as aluminum or silicide, or it may be made by less conductive materials.

When the hybrid bipolar/MOS component is constructed as described above, the bipolar emitter can also serve as a MOS source and the bipolar collector can also serve as a MOS drain. In consequence, the hybrid component of the present invention operates, in some respects, as if a bipolar transistor were coupled, in parallel, to a MOS transistor.

Preferably, the hybrid component of the present invention is manufactured on an insulating substrate using SOI technology. This reduces parasitic compacitance problems, and results in faster operation and lower power dissipation.

A hybrid bipolar/MOS inverter in accordance with the present invention includes a first hybrid bipolar/MOS component of a first type; a second hybrid bipolar/MOS component of a second type; an input coupled to the base/gate of both of the hybrid components; an output coupled to the collector/drains of both of the components; and a power source coupled between the emitter/source of the first hybrid component and the emitter/source of the second hybrid component. In one embodiment of the invention, the first hybrid component includes a PNP bipolar transistor portion, and the second hybrid component includes an NPN bipolar transistor portion. The resultant inverter operates on a voltage swing of approximately 0-0.8 volts with low power dissipation, high current driving capabilities, and high speed.

An advantage of the present invention is that a hybrid bipolar/MOS component is disclosed which combines the best features of transistor components based on bipolar technologies and MOS technologies.

Another advantage of this invention is that the hybrid bipolar/MOS component can be fabricated using conventional techniques, and in a very cost effective manner.

These and other objects and advantages of the present invention will no doubt become apparent to those skilled in the art upon a reading of the following descriptions and a study of the drawings.

Brief Description of the Drawings

Fig. 1 is a top plan view of a hybrid bipolar/MOS component in accordance with the present invention;

Fig. 2 is a cross-sectional view taken along line 2-2 of Fig. 1;

Fig. 3 is a cross-sectional view taken along line 3-3 of Fig. 1;

Fig. 4A is a schematic illustrating an approximately equivalent circuit for the hybrid bipolar/MOS component shown in Figs. 1-3;

Fig. 4B is a schematic symbol for the hybrid component shown in Fig. 4A;

Fig. 5A illustrates the transfer characteristics of the hybrid component when it is operating in a MOS-only mode;

Fig. 5B illustrates the transfer characteristics of the hybrid component when operating in a bipolar-only mode;

Fig. 5C illustrates the transfer characteristics of the hybrid component when operating in a hybrid, voltage-controlled bipolar/MOS (VCBM) mode;

Fig. 6 illustrates the conductance characteristics of they hybrid component;

Fig. 7 illustrates the transconductance characteristics of the hybrid component;

Fig. 8A is a schematic of an inverter utilizing a pair of hybrid bipolar/MOS devices in accordance with the present invention; and

Fig. 8B illustrates the transfer characteristics of the inverter shown in Fig. 8A.

Detailed Description of the Preferred Embodiments

Reference is now made in detail to a specific embodiment of the present invention, which illustrates the best mode presently contemplated for practicing the invention. Alternative embodiments are also briefly described as applicable.

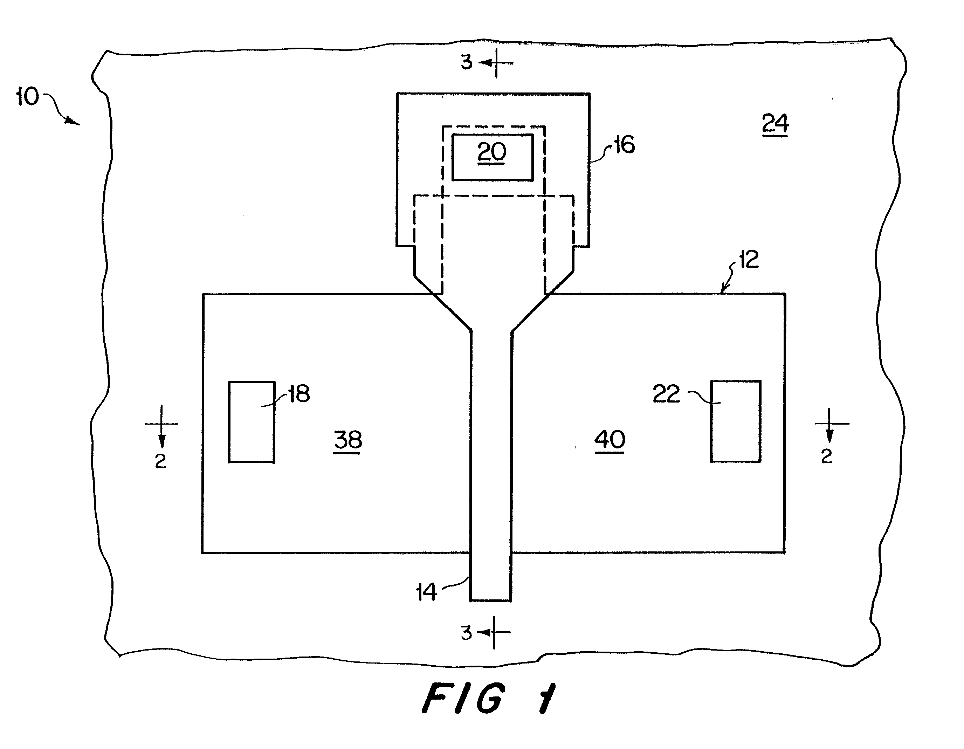

With reference to Fig. 1, a hybrid bipolar/MOS component 10 in accordance with the present invention includes a bipolar portion 12, a gate portion 14, and a connection portion 16. The hybrid component 10 also includes an emitter/source (E/S) contact 18, a base/gate (B/G) contact 20, and a collector/drain (C/D) contact 22.

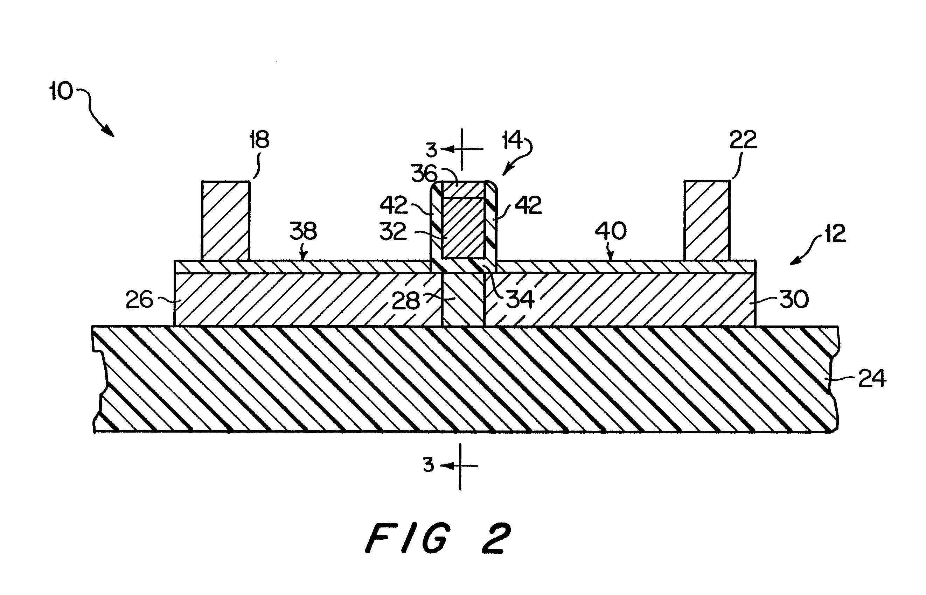

Referring now additionally to Fig. 2, the hybrid component 10 is preferably formed on an insulating substrate 24 using silicon-on-insulator (SOI) techniques. Insulating substrate 24 is preferably made from silicon dioxide, but can also be made from other commercially available insulating materials used in the production of integrated circuits, such as sapphire.

Bipolar portion 12 is deposited on insulating substrate 24 utilizing the aforementioned SOI techniques and includes a first region 26, a second region 28, and a third region 30. First region 26 and third region 30 are made from a semiconducting material, such as silicon, which is doped to produce a first conductivity type. Second region 28 is also made from a semiconducting material, such as silicon, which is doped to produce a second conductivity type. For ease of description, it will be assumed that first region 26 and third region 30 are doped as N-type semiconductors, and second region 28 is doped as a P-type semiconductor to produce an NPN bipolar transistor. Of course, bipolar portion 12 could also be configured as PNP bipolar transistor, as is well known to those skilled in the art.

As it is well known to those skilled in the art, the first (emitter) region 26 should be more heavily doped than the third (collector) region 30. The second region 28, which has the same lateral width as gate portion 14, should be made as thin as possible to maximize gain.

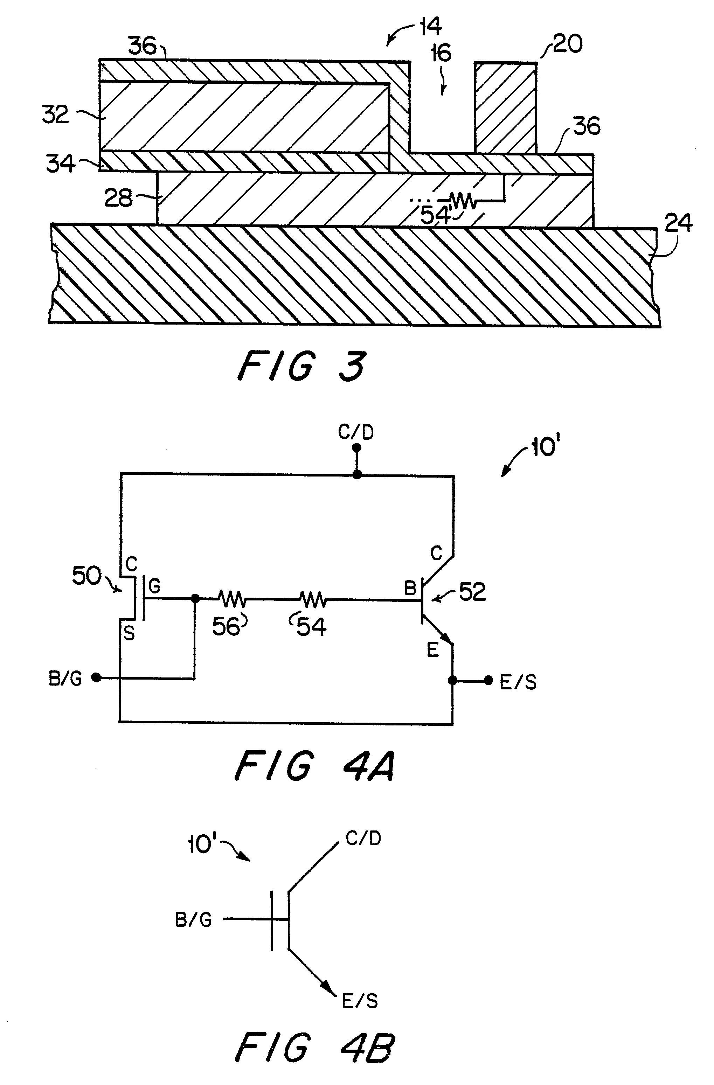

Referring now additionally to Fig. 3, gate portion 14 includes a gate conductor 32 and a gate insulator 34. Gate conductor 32 may be made from metal, such as aluminum, or other conductive materials such as silicide or polysilicon. Gate insulator 34 is preferably formed from silicon dioxide.

Connecting portion 16 includes a connecting layer 36, preferably formed from silicide. Silicide is a desirable connecting material for the present invention because it can provide a small, self-aligned connection between gate conductor 32 and second region 28. However, in some embodiments of the present invention other conductive materials, such as aluminum, are used to couple gate conductor 32 to second region 28. In all of these embodiments, a portion of the gate is essentially shorted to a portion of the base although, as will be discussed in greater detail subsequently, the intrinsic resistance of the semiconductor base provides resistance between operative portions of the gate and base.

Contacts 18, 20, and 22 are electrically coupled to first region 26, second region 28, and third region 30, respectively, by silicide layers 38, 36 and 40, respectively. The contacts 18, 20, and 22 are preferably made from aluminum. Insulating walls 42, made from silicon dioxide, flank gate portion 14 and, in conjunction with gate insulator 34, prevent regions 26, 28, and 30 from being shorted together.

The hybrid component 10 can be test operated in a bipolar mode or a MOS mode to provide comparisons to its proper operation in its voltage-controlled bipolar/MOS (VCBM) mode. In a bipolar test mode, the gate conductor 32 is grounded to minimize its influence on second region 28, and the base is disconnected from the gate. Region 26 then serves as an emitter, region 28 as a base, and region 30 as a collector of a bipolar transistor. The associated emitter, base, and collector contacts are, of course, contacts 18, 20, and 22, respectively.

When operating in a test MOS mode, the second region 28 is allowed to float, the base is disconnected from the gate, and the gate conductor 32 is coupled to a voltage source. As mentioned previously, second region 28 serves as the body of a MOSFET when in this mode, and is fully covered by gate portion 14. First region 26 serves as a source for the MOS transistor, and third region 30 serves as a drain for the MOS transistor.

When operating in its proper hybrid or VCBM mode, the hybrid component 10 has characteristics distinguishable from both bipolar and MOS transistors. When in this mode, first region 26 serves as an emitter/source E/S, region 28 serves as a base/gate B/G, and region 30 serves as a collector/drain C/D.

With hybrid components 10 fabricated with region 28 (and thus gate portion 14) having a width of less than one-half of a micron, current gains of up to 75 were observed. It appears that the current through the hybrid components 10 is close to the sum of the MOS transistor current and the bipolar transistor current. Due to various interactions between the bipolar and MOS aspects of the hybrid component 10, the total current through the device is actually about 10% less than the sum of the two aforementioned currents. It should be noted that this additive effect is not very noticeable for base-widths greater than about one micron. It is therefore important to use advanced VLSI techniques to produce sub-micron features in the hybrid component 10.

Since region 28 serves as both as the base of a bipolar transistor and as the body of the MOS transistor, the base current into region 28 creates a positive potential in that region, lowering the threshold voltage of the MOS transistor. In consequence, the threshhold voltage of the MOS transistor portion of the hybrid component 10 is lower in the "on" state than in the "off" state, resulting in an additional increase of drain current in the "on" state.

An approximately equivalent circuit 10'of a hybrid bipolar/MOS component is shown in Fig. 4A. The device 10' includes a MOS transistor 50 having a source S, gate G, and drain D; and a bipolar transistor 52 having an emitter E, base B, and collector C. The drain D is coupled to the collector C; the source S is coupled to the emitter E; and the gate G is coupled to the base B by a resistive element 54. Finally, contact B/G is coupled to gate G, contact C/D is coupled to drain D and collector C, and contact E/S is coupled to source S and emitter E.

The resistive element 54 is the intrinsic resistance of second region 28, which was alluded to previously. The intrinsic resistance is suggested by the resistive element 54′ in Fig. 3, and can be several thousand ohms. Resistive element 54′ is essentially the sum of the spreading base resistance of region 28 and the contact resistance between contact 20 and region 28.

In an alternate embodiment of the present invention, an additional resistive element 56 may be coupled in series with the intrinsic resistance element 54 to vary the operating characteristics of the device. This can be accomplished by providing a connective material between the gate and base which is not as conductive as silicide or aluminum. A schematic representation of the hybrid bipolar/MOS component 10′ is shown in Fig. 4B.

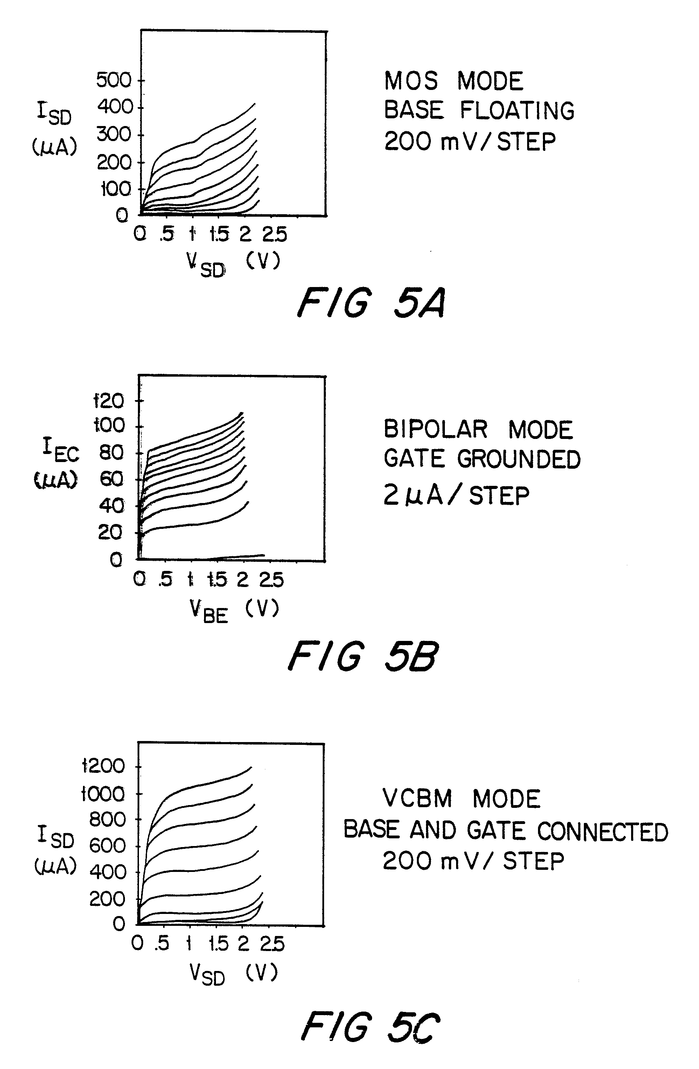

In Fig. 5A, the transfer characteristics of hybrid component 10 being operated in a MOS-only test mode is illustrated. The source-drain current $I_{SD}$ is plotted against the source-drain voltage $V_{SD}$, where the various traces on the graph represent 200 millivolt steps in the gate voltage. As can be seen, the slopes of the various traces are undesirably steep and have substantial non-linear excursions known as the "kink effect." It can therefore be concluded that the hybrid component 10 operating in a MOS-only test mode would not make a very good analog component because of severe distortion problems.

In Fig. 5B, the transfer characteristics of the hybrid component 10 in a bipolar-only test mode are shown. In this graph, the emitter-collector current $I_{EC}$ is plotted against the base-emitter voltage $V_{BE}$, with the steps between the traces being 20 microamperes. As can be seen, the traces are more linear than they were during the MOS-only test mode, but still have undesirably steep slope and still exhibit relatively low gain characteristics.

In Fig. 5C, the transfer characteristics of hybrid component in its operational hybrid or voltage controlled bipolar/MOS (VCBM) mode is illustrated. The source-drain current $I_{SD}$ is plotted against the source drain voltage $V_{SD}$, and the steps between the various traces is 200 millivolts.

It should be noted that the current is approximately four times greater in the VCBM mode shown in Fig. 5C than it is in the MOS-only test mode shown in Fig. 5A. Furthermore, the traces in the VCBM mode are quite linear and have a desirably small slope. Due to these characteristics, the hybrid component 10, when properly operated in its VCBM mode, is quite useful for both analog and digital application. Furthermore, when in its proper VCBM mode, the device 10 is voltage-controlled (as with a MOS transistor) but has high current gain (as with a bipolar transistor).

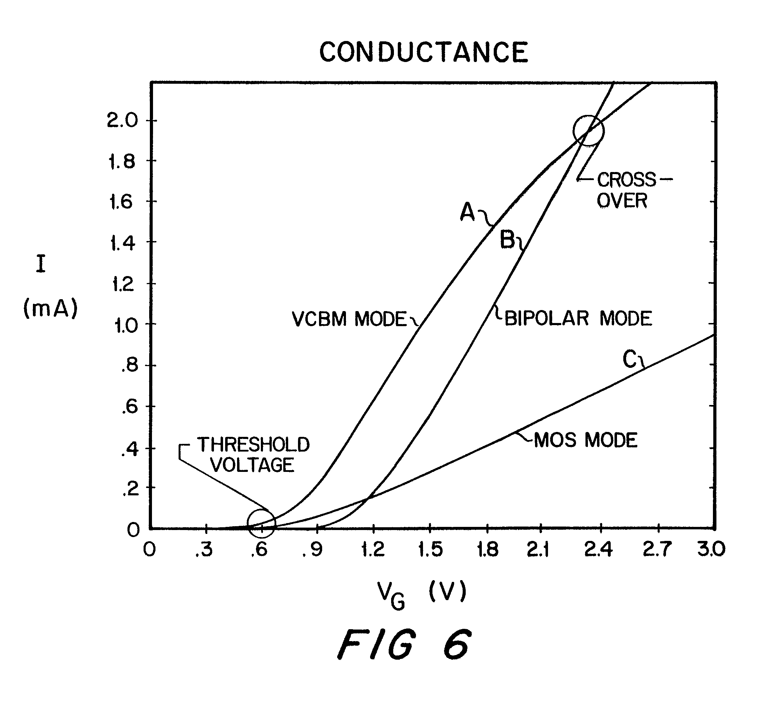

In Fig. 6, the conductance of hybrid component 10 is illustrated by plotting various currents against the gate voltage $V_G$. The collector-drain current $I_{CD}$ of the hybrid component 10 is shown in the curve A, while the base $I_B$ is shown in the curve B. When operated in the MOS mode, the drain current $I_D$ is shown in the curve C.

The threshold voltage appears to be approximately .6 volts for the hybrid component 10 when it is operated in either the VCBM mode or a MOS-only test mode. It should be noted that there is a crossover between the curves for the VCBM mode and a bipolar-only test mode at approximately 2.4 volts. Since the current gain $H_{FE}$ of the hybrid component 10 is given by the equation $H_{FE} = I_C/I_B$, the gain is greater than one when $V_G$ is less than 2.4 volts, and less than one when $V_G$ is greater than 2.4 volts. Therefore, the hybrid component 10 should be operated in the region between its threshold voltage of .6 volts and the crossover voltage of 2.4 volts.

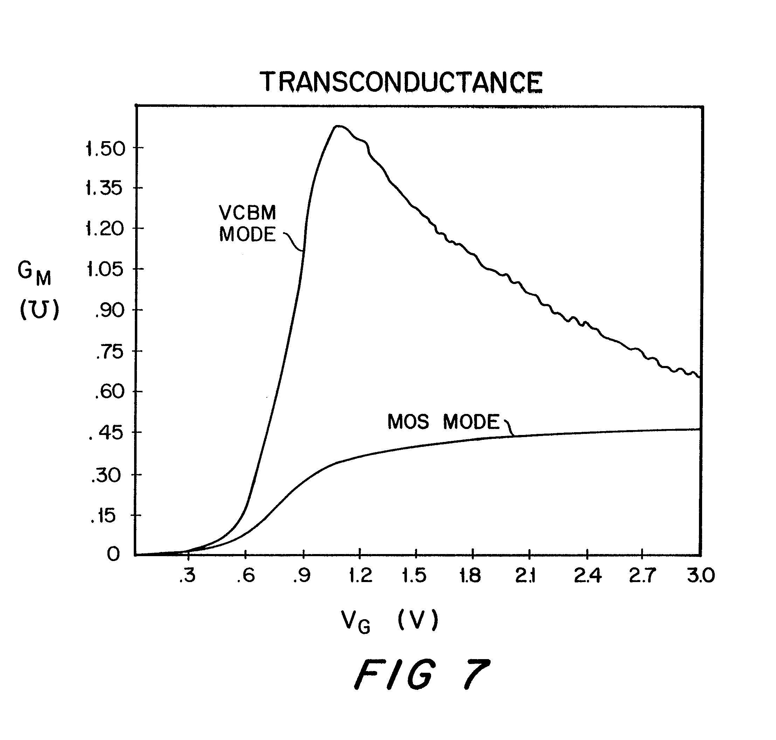

Referring now to Fig. 7, the transconductance $G_M$ of the hybrid component 10 is illustrated. Transconductance $G_M$ is define as the derivative of the collector current with respect to the gate voltage. In mathematical form, $G_m = dI_c/dV_G$.

It is, of course, desirable to have a transconductance which is as large as possible. As seen in Fig. 7, the transconductance $G_M$ for the hybrid component 10 is considerably better during the VCBM mode than it is in the MOS-only test mode. The transconductance $G_m$ for the hybrid component 10 operating in the VCBM mode appears to be at a maximum at approximately one volt.

From the conductance graph shown in Fig. 6 and the transconductance graph shown in Fig. 7, the operating ranges for the hybrid component 10 becomes apparent. Complete shut-off of the device 10 can be accomplished with a gate voltage $V_G = 0$ volts, and a maximum transconductance can be achieved by a gate voltage $V_G$ of approximately 1 volt. In actuality, the upper end of the operating range is preferably closer to 1.3 or 1.4 volts for a variety of reasons, including bipolar gain and compatibility considerations.

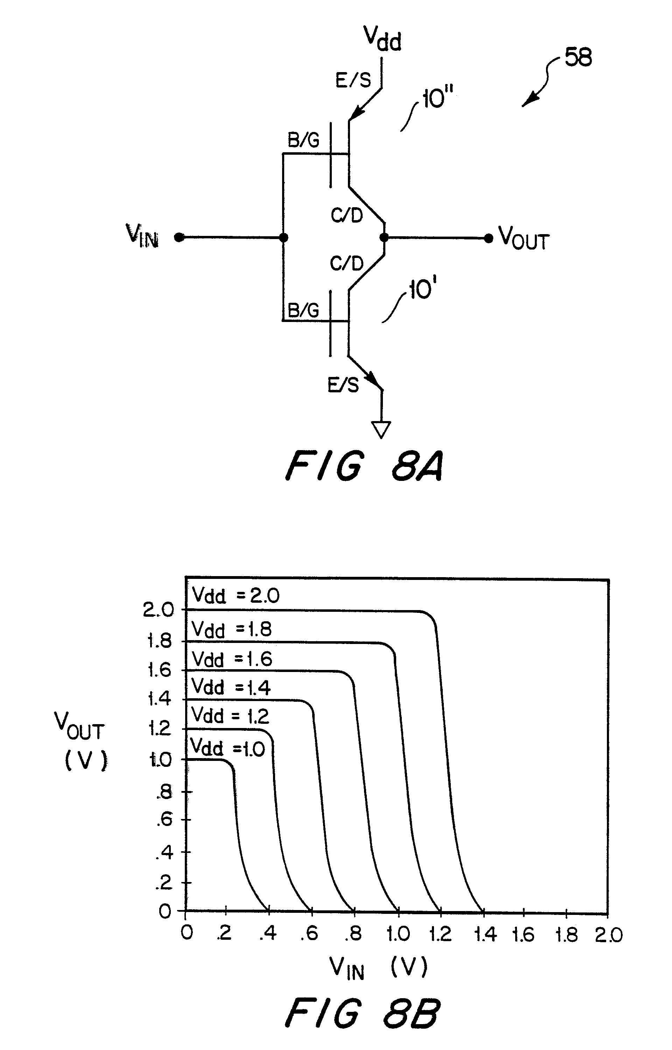

Referring now to Fig. 8A, an inverter 58 is shown which utilizes hybrid components 10′ and 10″. More specifically, inverter 58 includes a hybrid component 10′ as previously described, and a hybrid component 10″ of a different type. More specifially, hybrid component 10′ has an NPN bi-

polar transistor portion, while device 10″ has an NPN bipolar transistor portion. Otherwise, the contruction of components 10′ and 10″ are substantially the same.

An input $V_{IN}$ is coupled to the B/G inputs of components 10′ and 10″, and an output $V_{OUT}$ is coupled to coupled to terminals C/D of components 10′ and 10″. A voltage source $V_{DD}$ is coupled to the E/S terminal of component 10″, and the E/S terminal of component 10′ is coupled to ground.

In operation, a sufficiently positive voltage $V_{IN}$ tends to turn off hybrid component 10″ and turns on hybrid device 10′, pulling $V_{OUT}$ to ground. If $V_{IN}$ is grounded, hybrid component 10″ turns on and hybrid component 10′ turns off, pulling $V_{OUT}$ up to $V_{DD}$.

With reference to Fig. 8B, the transfer characteristics of the circuit of Fig. 8A are shown. As can be seen, the various traces exhibit very linear horizontal components, and fairly linear vertical components. These characteristics indicate that the inverter 58 of Fig. 8A is an almost ideal inverter in the range of 0-2 volts.

It should be noted that many publications describe the details of common techniques used in the fabrication process of integrated circuit components. See, for example, Semiconductor and Integrated Circuit Fabrication Techniques, published by Preston Publishing Co., Inc. These techniques can be generally employed in the fabrication of the structure of the present invention. Moreover, the individual manufacturing steps can be performed using commercially available integrated circuit fabrication machines. As specifically necessary to an understanding of the present invention, approximate technical data for the preferred embodiment is set forth based upon current technolgy. Future developments in this art may call for appropriate adjustments, as would be obvious to one skilled in the art.

The foregoing description of the preferred embodiment of the present invention has been presented for purposes of illustration and description. It is not intended to be exhaustive or to limit the invention to the precise form disclosed. Obviously, many modifications and variations will be apparent to practitioners skilled in this art. It is possible that the invention may be practiced in many fabrication technologies bipolar and MOS processes. Similarly, any process steps described might be interchangeable with other steps in order to achieve the same result. The embodiment was chosen and described in order to best explain the principles of the invention and its practical application, thereby enabling others skilled in the art to understand the invention. It is intended that the scope of the invention be defined by the claims appended hereto and to their equivalents.

## Claims

1. A hybrid bipolar/MOS component comprising:
bipolar transistor means having an emitter, a base, and a collector;
gate means located proximate said base; and
connection means coupling said gate means to said base.

2. A hybrid bipolar/MOS component as recited in claim 1 wherein said gate means includes gate conductor and gate insulator, where said gate insulator is disposed between said gate conductor and said base, and where said connection means couples said gate conductor to said base.

3. A hybrid bipolar/MOS component as recited in claim 1 wherein said connection means is highly conductive.

4. A hybrid bipolar/MOS component as recited in claim 1 wherein said connection means is not highly conductive.

5. A hybrid bipolar/MOS component as recited in claim 1 wherein said emitter serves as a source and said collector serves as a drain when operated in conjunction with said gate means.

6. A hybrid bipolar/MOS component forming a portion of an integrated circuit device, said hybrid bipolar/MOS component comprising:
a first region having a first conductivity type;
a second region having a second conductivity type, said second region abutting said first region;
a third region having said first conductivity type said third region abutting said second region;
gate means formed proximate said second region; and
connection means coupling said gate means to said second region.

7. A hybrid bipolar/MOS component as recited in claim 6 wherein said gate means includes a gate conductor and a gate insulator, where said gate insulator is disposed between said gate conductor and said second region.

8. A hybrid bipolar/MOS component as recited in claim 6 wherein said integrated circuit device includes an insulating substrate which supports said first region, said second region, and said thrid region of said hybrid bipolar/MOS component.

9. A hybrid bipolar/MOS component as recited in claim 6 wherein said connection means coupling said gate means to said second region includes a layer of silicide.

10. A hybrid bipolar/MOS component as recited in claim 6 further comprising first contact means coupled to said first region, second contact means coupled to said second region, and third contact means coupled to said third region.

11. A hybrid bipolar/MOS component comprising:

MOS transistor means including a source, a gate, and a drain;

bipolar transistor means including an emitter, a base, and a collector; and

first means coupling said gate to said base.

12. A hybrid bipolar/MOS component as recited in claim 11 wherein said first means is highly conductive.

13. A hybrid bipolar/MOS component as recited in claim 11 wherein said first means is not highly conductive.

14. A hybrid bipolar/MOS component as recited in claim 11 further comprising second means coupling said source to said emitter.

15. A hybrid bipolar/MOS component as recited in claim 14 further comprising third means coupling said drain to said collector.

16. A hybrid bipolar/MOS component as recited in claim 11 further comprising second means coupling said drain to said collector.

17. A hybrid bipolar/MOS inverter comprising:

a first hybrid bipolar/MOS component of a first type including a first emitter/source, a first base/gate, and a first collector/drain;

a second hybrid bipolar/MOS component of a second type including a second emitter/source, a second base/gate, and a second collector drain;

input means coupled to said first base/gate and to said second base/gate;

output means coupled to said first collector/drain and to said second collector/drain; and

power source means coupled between said first emitter/source and said second emitter/source.

18. A hybrid bipolar/MOS inverter as recited in claim 17 wherein said first hybrid bipolar/MOS component of said first type includes PNP bipolar transistor means having a first emitter, a first base, and a first collector; and first MOS transistor means having a first source, a first gate, and a first drain; where said first emitter is coupled to said first source, said first base is coupled to said first gate, and said first collector is coupled to said first drain; and where said power source means develops a first potential at said first emitter and said first source.

19. A hybrid bipolar/MOS inverter as recited in claim 18 wherein said second hybrid bipolar/MOS component of said second type includes NPN bipolar transistor means having a second emitter, a second base, and a second collector; and second MOS transistor means having a second source, a second gate, and a second drain; where said second emitter is coupled to said second source, said second base is coupled to said second gate, and said second collector is coupled to said second drain; and where said power source means develops a second potential at said second emitter and said second source which is less than said first potential.

FIG 1

0 251 682

FIG 2

0 251 682

FIG 3

FIG 4A

FIG 4B

MOS MODE
BASE FLOATING
200 mV/STEP

*FIG 5A*

BIPOLAR MODE
GATE GROUNDED
2 μA/STEP

*FIG 5B*

VCBM MODE
BASE AND GATE CONNECTED
200 mV/STEP

*FIG 5C*

CONDUCTANCE

FIG 6

# TRANSCONDUCTANCE

FIG 7

FIG 8A

FIG 8B